(19) Europäisches Patentamt

European Patent Office

Office européen des brevets

(11) **EP 1 309 086 A1**

(12) **EUROPEAN PATENT APPLICATION**

(43) Date of publication:
07.05.2003 Bulletin 2003/19

(51) Int Cl.$^7$: **H03K 5/19**

(21) Application number: **02102494.8**

(22) Date of filing: **25.10.2002**

(84) Designated Contracting States:
**AT BE BG CH CY CZ DE DK EE ES FI FR GB GR
IE IT LI LU MC NL PT SE SK TR**
Designated Extension States:
**AL LT LV MK RO SI**

(30) Priority: **02.11.2001 GB 1263573**

(71) Applicant: **Zarlink Semiconductor Limited
Swindon, Wiltshire SN2 2QW (GB)**

(72) Inventors:
• **ANDREW, Stephen, Paul
PL19 0ET, Tavistock (GB)**
• **EVERED, Jonathan, Francis
PL2 1PS, Plymouth (GB)**

(74) Representative: **Asquith, Julian Peter
Marks & Clerk,
4220 Nash Court,
Oxford Business Park South
Oxford, Oxfordshire OX4 2RU (GB)**

(54) **Digital clock detection**

(57) A digital clock detector for detecting whether a digital clock, for providing an output alternating between a high value and a low value, is running or stopped, comprises:

two or more digital delay gates connected to said clock, said delay gates being connected in a chain; and

logic circuitry arranged to determine whether the logic levels on either side of each of said gates are the same or different, and to thereby provide an output which indicates whether said digital clock is running, or whether said digital clock has stopped while providing an output which corresponds to either said high value or said low value.

FIG 1

EP 1 309 086 A1

**Description**

The invention relates to the detection of digital clock signals in a digital circuit.

Historically, at a board level implementation, the detection of a clock signal would be done using analogue components in a timer, monostable or similar configuration, e.g. the classic 555 timer. At the chip level, the use of analogue libraries is made in CMOS integrated circuit design for modules such as phase locked loops and other analogue functions, but use of such libraries may be undesirable for certain applications. This may be the case if, for example, analogue components cannot be simulated using digital simulators, or if no analogue library is available for the chosen technology, or for cost or other reasons.

According to the invention there is provided a digital clock detector and a method as set out in the accompanying claims.

An embodiment of the invention will now be described, by way of example only, with reference to the accompanying drawings, in which:

Figure 1 shows a digital clock detector, in accordance with an embodiment of the invention; and

Figure 2 shows a timing diagram illustrating the propagation of a clock signal through delay gates of the detector.

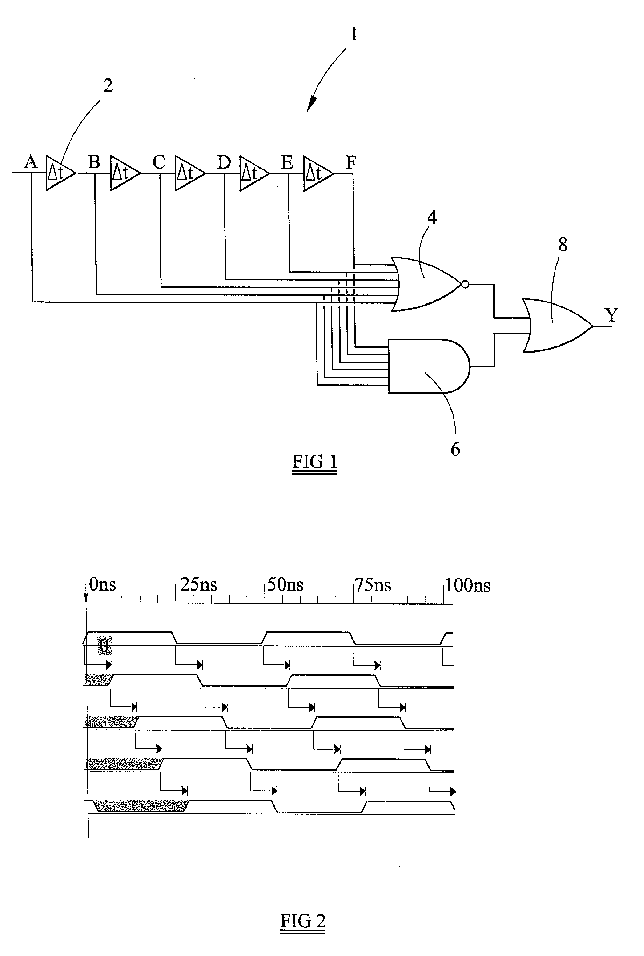

Figure 1 shows a digital clock detector 1, which comprises a chain of digital delay gates 2 connected to a clock source (not shown). By delaying the clock transitions through the gates 2, it is possible to examine the state between each delay gate 2, and establish whether or not the clock is still toggling. The arrangement of delay gates 2 is as shown in Figure 1.

The inputs and outputs of the delay gates 2 are connected to a logical NOR gate 4 and a logical AND gate 6, as shown in Figure 1. The outputs of the gates 4 and 6 are connected to a logical OR gate 8.

The digital clock detector circuit 1 makes use of only digital components.

When the required number of delay gates 2 is used, performing a logical-AND and a logical-NOR of each tap in the delay chain and finally a further logical-OR on the result provides a signal which indicates the 'running'/'stopped' condition of the clock.

If the clock stops then each stage between successive delay gates 2 settles to the same logic level, either all high or all low. If the clock is running, provided that suitable delays and a suitable number of delay stages are used, then at least one of the stages between successive gates 2 will be different from the others. The resultant signal (Y) will yield a low (0) if the clock is running, and a high (1) if the clock has stopped. This is illustrated in Table 1 below.

| A | B | … | F | Y | Clock condition |
|---|---|---|---|---|---|
| 0 | 0 | … | 0 | 1 | Stopped |
| 0 | 0 | … | 1 | 0 | Running |
| 0 | 1 | … | 0 | 0 | Running |
| 0 | 1 | … | 1 | 0 | Running |
| 1 | 0 | … | 0 | 0 | Running |
| 1 | 0 | … | 1 | 0 | Running |
| 1 | 1 | … | 0 | 0 | Running |
| 1 | 1 | … | 1 | 1 | Stopped |

Table 1 – Illustration of clock condition

The number of delay gates required, $n$, is dependent on the performance of the gates and the frequency of the clock signal. A calculation is required to determine n, it being a function of the delay range for the delay gate in question. The delay of a particular gate will have a minimum delay and a maximum delay specification. Thus the delay of the physical gate will be expected to sit within this range and will be governed by such factors as parasitic loading on the gate and its specific operating temperature, operating voltage and silicon processing variances during manufacture. Since these factors cannot be quantified at the time of design a number of gates must be used. This number allows for the delay to be anywhere within the range, $t_{short}$ to $t_{long}$. If a sufficient number of delay gates is not used, then a condition may arise whereby the digital clock detector circuit indicates that the clock has stopped, when it is actually still running. The effect of using too many delay gates is that the *clock stopped* condition may be indicated a little later in time than would be possible by using the optimum number of gates. Also, using more gates than required is undesirable since it wastes space on silicon.

Figure 2 is a timing diagram showing a clock signal, and how it may look as it propagates through the series of delay gates. The diagram illustrates the requirement for the sum of the propagation delays through the gates to be more than a half-cycle of the clock. We can see by the shaded area that it is only when the fifth delay (at the bottom of the figure) is added, that the accumulated delay is greater than half a cycle of the original clock signal. If the fifth gate had not been added in this example, then there is a period of time every clock cycle when the result of an exclusive or operation on all the delay stages would falsely indicate that the clock had stopped. The diagram shows that it is a requirement for the accumulative delay to be greater than half a cycle of the original clock signal.

The delay range of the delay gate is important. Some delay gates may not be suitable for detecting a certain clock. If the range between $t_{short}$ and $t_{long}$ encompasses the half period (T/2) of the clock to be detected (i.e. $t_{short} \leq T/2 \leq t_{long}$), the delay chain cannot be guaranteed to work. This is because it is feasible that the delay gates may delay the clock for exactly half the clock period. In this case the circuit would falsely detect a stopped clock. In order to be guaranteed to operate properly, $t_{long}$ must be shorter than a half clock cycle, or $t_{short}$ must be longer than a half clock cycle. Also the accumulative delay through the chain must be greater than a half cycle of the clock period, in the worst case of the delay gate range.

$$n \times t_{short} > \frac{T}{2} \qquad \text{Eqn 1}$$

$$n \times (T - t_{long}) > \frac{T}{2} \qquad \text{...Eqn 2}$$

These requirements for functionality are summarised by the expressions shown below. The number of delay gates used (n) must satisfy both of equations (3) and (4) below.

$$n > \left( \frac{T}{2 \times t_{short}} \right) \qquad \text{....Eqn 3}$$

$$n > \left( \frac{T}{2(T - t_{long})} \right) \qquad \text{....Eqn 4}$$

**Claims**

1. A digital clock detector for detecting whether a digital clock, for providing an output alternating between a high value and a low value, is running or stopped, the detector comprising:

   two or more digital delay gates connected to said clock, said delay gates being connected in a chain; and logic circuitry arranged to determine whether the logic levels on either side of each of said gates are the same or different, and to thereby provide an output which indicates whether said digital clock is running, or whether said digital clock has stopped while providing an output which corresponds to either said high value or said low value.

**EP 1 309 086 A1**

**2.** A detector as claimed in claim 1, wherein said logic circuitry comprises a logic AND gate and a logic NOR gate, and wherein the inputs and outputs of said delay gates are all connected to the inputs of both said logic AND gate and said logic NOR gate.

**3.** A detector as claimed in claim 2, wherein said logic circuitry further comprises a logic OR gate, and wherein the outputs of said logic AND and NOR gates are connected to the inputs of said logic OR gate.

**4.** A detector as claimed in any preceding claim wherein said delay gates each provide a delay which varies between a minimum value of $t_{short}$, and a maximum value of $t_{long}$, wherein the period of the clock cycle is T, and wherein the number of delay gates n satisfies the following condition:

$$n > \left( \frac{T}{2 \times t_{short}} \right)$$

**5.** A detector as claimed in claim 4, wherein the number of delay gates n also satisfies the following condition:

$$n > \left( \frac{T}{2(T - t_{long})} \right)$$

**6.** A detector as claimed in claim 4 or 5, wherein $t_{short} > T/2$, or $t_{long} < T/2$.

**7.** A method of detecting whether a digital clock, for providing an output alternating between a high value and a low value, is running or stopped, the method comprising:

delaying the digital clock signal by one or more multiples of a delay period, using one or more digital delay gates;

determining the logic level after each delay; and

determining whether said logic levels are the same or different, so as to thereby determine whether said digital clock is running, or whether said digital clock has stopped while providing an output which corresponds to either said high value or said low value.

**8.** A method as claimed in claim 7, wherein the steps of the method are carried out by a detector as claimed in any one of claims 1 to 6.

4

1

2

A $\Delta t$ B $\Delta t$ C $\Delta t$ D $\Delta t$ E $\Delta t$ F

4

8

Y

6

FIG 1

0ns    25ns    50ns    75ns    100ns

0

FIG 2

5

**European Patent Office**

**EUROPEAN SEARCH REPORT**

Application Number

EP 02 10 2494

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | US 5 670 901 A (YOSHIDA YUTAKA) 23 September 1997 (1997-09-23) * column 11, line 24 - column 11, line 38; figure 1 * * column 5, line 35 - column 5, line 37 * --- | 1-8 | H03K5/19 |
| X | EP 0 804 000 A (SANYO ELECTRIC CO) 29 October 1997 (1997-10-29) * figure 7 * --- | 1-3,7,8 | |
| A | US 3 903 474 A (WILEY PAUL RONALD) 2 September 1975 (1975-09-02) * column 2, line 39 - column 4, line 29; claims 1,5,6,8; figure 1 * --- | 4-6,8 | |
| A | US 4 698 829 A (DI GIULIO PETER C) 6 October 1987 (1987-10-06) * column 3, line 1 - column 5, line 46; figure 1 * ----- | 1-3,7,8 | |

| | | | TECHNICAL FIELDS SEARCHED (Int.Cl.7) |
|---|---|---|---|
| | | | H03K |

The present search report has been drawn up for all claims

| Place of search | Date of completion of the search | Examiner |
|---|---|---|
| MUNICH | 16 January 2003 | Waters, D |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**
EP 02 10 2494

This annex lists the patent family members relating to the patent documents cited in the above-mentioned European search report.
The members are as contained in the European Patent Office EDP file on
The European Patent Office is in no way liable for these particulars which are merely given for the purpose of information.

16-01-2003

| Patent document cited in search report | | Publication date | Patent family member(s) | | Publication date |
|---|---|---|---|---|---|
| US 5670901 | A | 23-09-1997 | JP | 8084161 A | 26-03-1996 |
| EP 0804000 | A | 29-10-1997 | JP | 9289465 A | 04-11-1997 |
| | | | EP | 0804000 A2 | 29-10-1997 |
| | | | US | 6256359 B1 | 03-07-2001 |
| US 3903474 | A | 02-09-1975 | CA | 1022629 A1 | 13-12-1977 |
| US 4698829 | A | 06-10-1987 | NONE | | |

EPO FORM P0459

For more details about this annex : see Official Journal of the European Patent Office, No. 12/82